(19) **Europäisches Patentamt / European Patent Office / Office européen des brevets**

(11) **EP 4 526 975 B1**

(12) **FASCICULE DE BREVET EUROPEEN**

(45) Date de publication et mention de la délivrance du brevet:
**14.01.2026   Bulletin 2026/03**

(21) Numéro de dépôt: **23730164.3**

(22) Date de dépôt: **17.05.2023**

(51) Classification Internationale des Brevets (IPC):
*H02J 7/00* (2026.01)

(52) Classification Coopérative des Brevets (CPC):
**H02J 7/0048**

(86) Numéro de dépôt international:
**PCT/FR2023/050706**

(87) Numéro de publication internationale:
**WO 2023/222978 (23.11.2023 Gazette 2023/47)**

(54) **ESTIMATION D'UN ÉTAT D'ÉNERGIE D'UNE BATTERIE**

SCHÄTZUNG EINES ENERGIEZUSTANDS EINER BATTERIE

ESTIMATING A STATE OF ENERGY OF A BATTERY

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **20.05.2022   FR 2204853**

(43) Date de publication de la demande:
**26.03.2025   Bulletin 2025/13**

(73) Titulaires:
- **Safran Electrical & Power**
  **31702 Blagnac (FR)**
- **Université de Technologie de Compiègne**
  **60200 Compiègne (FR)**
- **Centre National de la Recherche Scientifique**
  **75016 Paris (FR)**

(72) Inventeurs:
- **VENDRAME, Fernanda**
  **77550 MOISSY-CRAMAYEL (FR)**
- **FORGEZ, Christophe**
  **60200 COMPIEGNE (FR)**

(74) Mandataire: **Gevers & Orès**
**Immeuble le Palatin 2**
**3 Cours du Triangle**
**CS 80165**
**92939 Paris La Défense Cedex (FR)**

(56) Documents cités:
**WO-A1-2020/131450      WO-A1-2021/254620
US-A1- 2016 083 932**

- LI KAIYUAN ET AL: "A Practical Lithium-Ion Battery Model for State of Energy and Voltage Responses Prediction Incorporating Temperature and Ageing Effects", IEEE TRANSACTIONS ON INDUSTRIAL ELECTRONICS, IEEE SERVICE CENTER, PISCATAWAY, NJ, USA, vol. 65, no. 8, 1 August 2018 (2018-08-01), pages 6696 - 6708, XP011682138, ISSN: 0278-0046, [retrieved on 20180330], DOI: 10.1109/TIE.2017.2779411
- ZHENG LINFENG ET AL: "[Title Page] Novel Methods for Estimating Lithium-Ion Battery State of Energy and Maximum Available Energy", 1 January 2019 (2019-01-01), XP093036314, Retrieved from the Internet <URL:https://opus.lib.uts.edu.au/bitstream/10453/117841/4/2-s2.0-84973866023%20%20Novel%20Methods%20for%20Estimating%20Lithium-Ion%20Battery%20State%20of%20Energy%20and%20Maximum%20Available%20Energy%20PDF.pdf> [retrieved on 20230330]

EP 4 526 975 B1

- **MA L. ET AL: "State of Charge and State of Energy Estimation for Lithium-Ion Batteries Based on a Long Short-Term Memory Neural Network", vol. 37, 1 May 2021 (2021-05-01), NL, pages 102440, XP093036322, ISSN: 2352-152X, Retrieved from the Internet <URL:https://www. sciencedirect.com/science/article/pii/ S2352152X21001924/pdfft? md5=7038f08776d2d6318d0adb568405c9f6& pid=1-s2.0-S2352152X21001924-main.pdf> DOI: 10.1016/j.est.2021.102440**

**Description**

**Domaine technique de l'invention**

La présente invention concerne un procédé d'estimation d'un état d'énergie d'une cellule d'une batterie, ainsi qu'un programme d'ordinateur, un dispositif et un aéronef associés.

**Arrière-plan technologique**

L'état d'énergie (de l'anglais « State Of Energy » également désigné par l'acronyme SOE) d'une cellule de batterie indique la quantité d'énergie disponible dans la cellule. Cette notion est donc différente de l'énergie totale stockée, puisqu'une partie de l'énergie totale stockée peut ne pas être utilisable et donc disponible.

Le SOE peut être exprimé en valeur absolue (Wh) ou relative par rapport à l'énergie maximale que peut avoir la batterie (%). Le SOE n'est pas une grandeur mesurable, donc il doit être estimé à partir de mesures disponibles sur la cellule : courant échangé au travers de bornes de la cellule, tension aux bornes de la cellule et température de la cellule.

Pour cela, il est connu d'utiliser un réseau de neurones donnant le SOE à un instant donné à partir du courant, de la tension et de la température à cet instant. Un exemple est le document US 2016/083932 ou le document XP011682138 de l'IEEE.

Cependant, un tel réseau de neurones n'est pas un système déterministe. Il est très difficile d'obtenir une certification dans le domaine aéronautique, en particulier, dans un aéronef hybride ou complètement électrique, lorsque la batterie est utilisée par le système propulsif.

L'invention a donc pour but de fournir une méthode alternative d'estimation d'un état d'énergie d'une cellule d'une batterie, pour laquelle une certification peut être obtenue.

**Résumé de l'invention**

Il est donc proposé un procédé d'estimation d'un état d'énergie d'une cellule d'une batterie pour un instant donné, la cellule présentant deux bornes, caractérisé en ce qu'il comporte :

- une réception de mesures pour l'instant donné d'une température de la cellule, d'une tension aux bornes de la cellule et d'un courant échangé par la cellule au travers de ses bornes ;

- une estimation d'une résistance interne de la cellule pour l'instant donné ;

- une estimation d'une tension de circuit ouvert de la cellule pour l'instant donné à partir de la tension et du courant mesurés, et de la résistance interne estimée, par exemple en ajoutant à la tension mesurée, une tension de la résistance interne résultant d'un passage du courant mesuré dans la résistance interne ;

- une estimation d'une énergie totale délivrée par la cellule jusqu'à l'instant donné, à partir de la température et du courant mesurés, et de la tension de circuit ouvert estimée, en utilisant des associations prédéfinies entre des valeurs d'énergie totale délivrée par la cellule et des valeurs de température, de courant et de tension de circuit ouvert ;

- une estimation d'une énergie maximale pouvant être délivrée par la cellule, en utilisant les associations prédéfinies et en supposant que la température et le courant restent constants à leurs mesures pour l'instant donné ; et

- une estimation de l'état d'énergie de la cellule pour l'instant donné, en retranchant l'énergie totale délivrée estimée de l'énergie maximale estimée.

L'invention peut en outre comporter l'une ou plusieurs des caractéristiques additionnelles suivantes, selon toute combinaison techniquement possible.

Avantageusement, l'estimation de la résistance interne pour l'instant donné est réalisée par une mesure volt-ampérométrique.

Avantageusement également, l'estimation de la résistance interne à l'instant donné, comporte :

- une estimation préalable de la résistance interne pour l'instant donné à partir de la température et du courant mesurés à l'instant donné, en utilisant des associations prédéfinies entre des valeurs de la résistance interne et des valeurs de température et de courant ;
- une correction de l'estimation préalable en la multipliant par un rapport de correction entre :

3

- • une estimation de la résistance interne à un instant antérieur à partir d'une mesure volt-ampérométrique, et

- • une estimation de la résistance interne à l'instant antérieur à partir de la température et du courant mesurés à l'instant antérieur, en utilisant les associations prédéfinies entre des valeurs de la résistance interne et des valeurs de température et de courant.

Avantageusement également, l'estimation de la résistance interne à l'instant donné est réalisée indépendamment d'un état de charge de la cellule.

Avantageusement également, les associations prédéfinies entre des valeurs d'énergie totale délivrée par la cellule et des valeurs de température, de courant et de tension de circuit ouvert sont sous la forme d'une table.

Avantageusement également, la table donne l'énergie totale délivrée en fonction de la tension de circuit ouvert, à température et courant constants, pour plusieurs combinaisons de température et de courant.

Avantageusement également, l'énergie maximale est l'énergie totale délivrée pour une tension de circuit ouvert minimale prévue par les associations prédéfinies, à la température et au courant mesurés à l'instant donné.

Il est également proposé un programme d'ordinateur téléchargeable depuis un réseau de communication et/ou enregistré sur un support lisible par ordinateur, caractérisé en ce qu'il comprend des instructions pour l'exécution des étapes d'un procédé selon l'invention, lorsque ledit programme est exécuté sur un ordinateur.

Il est également proposé un dispositif d'estimation d'un état d'énergie d'une cellule d'une batterie pour un instant donné, la cellule présentant deux bornes entre lesquelles un système électrique est connecté, caractérisé en ce qu'il comporte :

- un module de réception, pour l'instant donné, de mesures d'une température de la cellule, d'une tension aux bornes de la cellule et d'un courant échangé par la cellule au travers de ses bornes ;

- un module d'estimation d'une résistance interne de la cellule pour l'instant donné ;

- un module d'estimation d'une tension de circuit ouvert de la cellule pour l'instant donné à partir de la tension et du courant mesurés, et de la résistance interne estimée, par exemple en ajoutant à la tension mesurée, une tension de la résistance interne résultant d'un passage du courant mesuré dans la résistance interne ;

- un module d'estimation d'une énergie totale délivrée par la cellule à partir de la température et du courant mesurés, et de la tension de circuit ouvert estimée, en utilisant des associations prédéfinies entre des valeurs d'énergie totale délivrée par la cellule et des valeurs de température, de courant et de tension de circuit ouvert ; et

- un module d'estimation d'une énergie maximale pouvant être délivrée par la cellule en supposant que la température et le courant restent constants à leurs mesures pour l'instant donné ; et

- un module d'estimation de l'état d'énergie de la cellule pour l'instant donné, en retranchant l'énergie totale délivrée estimée de l'énergie maximale estimée.

Il est également proposé un aéronef comportant :

- une batterie comportant au moins une cellule présentant deux bornes ;

- un capteur d'une température de la cellule ;

- un capteur d'un courant échangé par la cellule au travers de ses bornes ;

- un capteur d'une tension entre les bornes de la cellule ; et

- un dispositif d'estimation d'un état d'énergie de la cellule, selon l'invention.

**Brève description des figures**

L'invention sera mieux comprise à l'aide de la description qui va suivre, donnée uniquement à titre d'exemple et faite en se référant aux dessins annexés dans lesquels :

- la figure 1 est une vue fonctionnelle d'un aéronef dans lequel l'invention est mise en œuvre,

- la figure 2 est une vue fonctionnelle de modules d'un programme d'ordinateur d'un dispositif d'estimation d'un état d'énergie d'une cellule d'une batterie de l'aéronef de la figure 1,

- la figure 3 est un graphique illustrant l'évolution d'une énergie totale délivrée par la cellule en fonction d'une tension de circuit ouvert de cette cellule, pour plusieurs combinaisons de température et de courant échangé par la batterie,

- la figure 4 est un schéma électrique d'un modèle de la cellule de la batterie,

- la figure 5 est un schéma bloc d'un procédé de calcul d'associations entre l'énergie totale et la tension de circuit ouvert, pour plusieurs combinaisons de température et de courant, à partir du modèle de la figure 4, et

- la figure 6 est un schéma bloc d'un procédé d'estimation d'un état d'énergie de la batterie.

## Description détaillée de l'invention

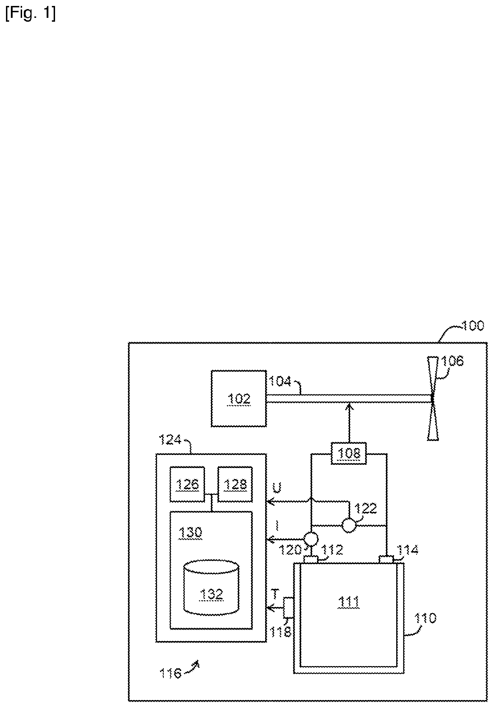

En référence à la figure 1, un exemple d'un aéronef 100 dans lequel l'invention est mise en œuvre, va à présent être décrit.

L'aéronef 100 comporte tout d'abord une turbomachine 102 présentant un arbre de sortie 104.

L'aéronef 100 comporte en outre une soufflante 106 conçue pour propulser l'aéronef 100. La soufflante 106 est en particulier connectée à l'arbre de sortie 104 de la turbomachine 102 afin d'être entraînée par cette dernière.

L'aéronef 100 comporte en outre une machine électrique 108 conçue par exemple pour fonctionner en moteur électrique pour entraîner l'arbre de sortie 104, à la place ou bien en complément de la turbomachine 102. Alternativement ou bien en complément, la machine électrique 108 est conçue pour fonctionner en génératrice pour fournir de l'énergie électrique à partir de la rotation de l'arbre de sortie 104.

L'aéronef 100 comporte en outre une batterie 110 comportant au moins une cellule 111. Dans l'exemple décrit, une seule cellule 111 est prévue. La cellule 111 présente deux bornes 112, 114 entre lesquelles un système électrique est connecté. Le système électrique est conçu pour sélectivement se comporter en charge électrique et être alimenté électriquement par la batterie 110 et se comporter en source électrique pour recharger la batterie 110. Alternativement, le système électrique peut se comporter toujours en charge électrique ou bien toujours en source électrique. Le système électrique comporte par exemple la machine électrique 108.

L'aéronef 100 comporte en outre un système 116 de surveillance de la cellule 111.

Le système de surveillance 116 comporte tout d'abord un capteur 118 d'une température T de la cellule 111.

Le système de surveillance 116 comporte en outre un capteur 120 d'un courant I échangé (c'est-à-dire fourni ou bien reçu) par la cellule 111 au travers de ses bornes 112, 114.

Le système de surveillance 116 comporte en outre un capteur 122 d'une tension U entre les bornes 112, 114 de la cellule 111.

Les capteurs 118, 120, 122 sont conçus pour fournir des mesures de respectivement la température T, le courant et la tension U, ces mesures étant soit directes soit indirectes par déduction à partir d'une ou plusieurs autres grandeurs physiques.

Le système de surveillance 116 comporte en outre un dispositif 124 de surveillance de la cellule 111. Le dispositif de surveillance 124 est en particulier conçu pour estimer un état de charge (de l'anglais « State Of Charge », également désigné par l'acronyme SOC) de la cellule 111, à partir de la température T, du courant I et de la tension U, respectivement mesurés par les capteurs 118, 120, 122.

Dans l'exemple décrit, le dispositif de traitement de données 124 est un système informatique comportant une unité 126 de traitement de données (telle qu'un microprocesseur) et une mémoire principale 128 (telle qu'une mémoire RAM, de l'anglais « Random Access Memory ») accessible par l'unité 126 de traitement de données. Le système informatique comporte en outre par exemple une interface réseau et/ou un support lisible par ordinateur, comme par exemple un support local (tel qu'un disque dur local 130) ou bien un support distant (tel qu'un disque dur distant et accessible via par l'interface réseau au travers d'un réseau de communication) ou bien encore un support amovible (tel qu'une clé USB, de l'anglais « Universal Serial Bus », ou bien un CD, de l'anglais « Compact Disc » ou bien un DVD, de l'anglais « Digital Versatile Disc ») lisible au moyen d'un lecteur approprié du système informatique (tel qu'un port USB ou bien un lecteur de disque CD et/ou DVD). Un programme d'ordinateur 132 contenant des instructions pour l'unité 126 de traitement de données est enregistré sur le support 130 et/ou téléchargeable via l'interface réseau. Ce programme d'ordinateur 132 est par exemple destiné à être chargé dans la mémoire principale 128, afin que l'unité 126 de traitement de données exécute ses instructions. Pour faciliter la description du programme d'ordinateur 132, les instructions seront décrites par la suite comme organisées en modules logiciels. Cependant, cette présentation ne préjuge pas de la forme du programme d'ordinateur, qui peut être quelconque.

Alternativement, tout ou partie de ces modules pourrait être implémenté sous forme de modules matériels, c'est-à-dire sous forme d'un circuit électronique, par exemple micro-câblé, ne faisant pas intervenir de programme d'ordinateur.

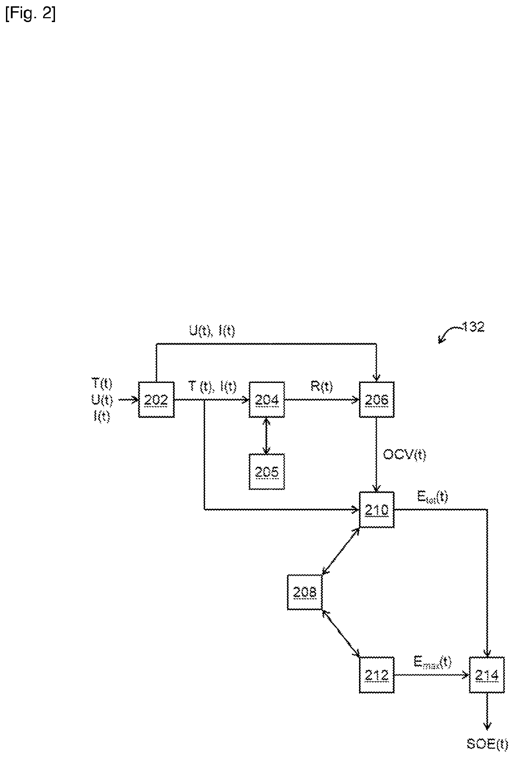

En référence à la figure 2, un exemple de mise en œuvre du programme d'ordinateur 132 va à présent être décrit.

Le programme d'ordinateur 132 comporte tout d'abord un module 202 conçu pour recevoir, de la part des capteurs 118, 120, 122, des mesures T(t), U(t), I(t) pour l'instant t de respectivement la température T, la tension U et le courant I. Par exemple, ces mesures T(t), U(t), I(t) sont acquises à l'instant t. Alternativement, une ou plusieurs de ces mesures pourrait être acquise antérieurement à l'instant t et réutilisé pour l'instant t.

Le programme d'ordinateur 132 comporte en outre un module 204 conçu pour estimer une résistance interne R de la cellule 111 pour l'instant t, par exemple à partir de la mesure T(t) de la température T et de la mesure I(t) du courant I, de préférence indépendamment d'un état de charge (de l'anglais « State Of Charge » également désigné par l'acronyme SOC) de la cellule 111.

De préférence, le module 204 est conçu, pour au moins certains instants t, pour estimer la résistance interne R par une mesure volt-ampérométrique, par exemple par une division d'une variation de la tension U mesurée par une variation du courant I mesuré :

[Math. 1]

$$R(t) = \Delta U(t)/\Delta I(t)$$

Par exemple, le programme d'ordinateur 132 peut comporter une table 205 associant des valeurs de la résistance interne R à des valeurs de la température T et du courant I, par exemple pour un état de charge SOC prédéfini et arbitraire de la cellule 111, par exemple 50%. La table 205 se présente par exemple sous la forme (le courant I est exprimé en courant nominal de la cellule, noté C pour taux de courant (de l'anglais « current rate »)) :

[Table 1]

| R (Ω) | T (°C) | I (C) |
|-------|--------|-------|
| 0,1   | 25     | 1     |
| ...   | ...    | ...   |

Le module 204 peut alors être conçu pour calculer un rapport de correction K entre l'estimation R(t) de la résistance R et une autre estimation $R_{table}(t)$ obtenue en utilisant la table 205 à partir de la mesure T(t) de la température T et de la mesure I(t) du courant I, par exemple par interpolation :

[Math. 2]

$$K = R(t)/R_{table}(t)$$

Dans ce cas, pour d'autres instants t, le module 204 est par exemple conçu pour réaliser une estimation préalable $R_{table}(t)$ de la résistance interne R pour l'instant donné t à partir de la mesure T(t) de la température T et de la mesure I(t) du courant I, en utilisant la table 205. Par exemple, le module 204 est conçu pour déterminer l'estimation préalable $R_{table}(t)$ par interpolation. Le module 204 peut alors être conçu pour corriger l'estimation préalable $R_{table}(t)$ en la multipliant par le rapport K préalablement obtenu comme expliqué ci-dessus :

[Math. 3]

$$R(t) = K \cdot R_{table}(t)$$

Il sera apprécié que les estimations de la résistance interne R à partir de la table 205 sont ainsi réalisées en supposant que l'état de charge SOC de la cellule 111 est à une valeur prédéfinie et arbitraire, même si l'état de charge réel de la cellule 111 à l'instant considéré est différent.

En outre, alternativement, les associations pourraient prendre la forme, à la place de la table 205, d'une formule liant la résistance interne R la température T et au courant I.

Du fait que la résistance interne R est mesurée au moins à certains instants, il est possible de tenir compte rapidement de la modification imprévisible de la résistance interne R au cours du temps, résultant du vieillissement de la cellule 111, et donc de la manière dont la batterie 110 est utilisée. Cette prise en compte rapide ne serait pas possible avec un réseau de neurones, qui est une « boîte noire » ne comportant donc pas un paramètre modifiable représentatif de la résistance interne. Au mieux, il faudrait prévoir un réentraînement du réseau de neurones pendant son utilisation, mais cela prendrait du temps et ne permettrait pas de suivre les modifications de la résistance interne R.

Le programme d'ordinateur 132 comporte en outre un module 206 conçu pour estimer une tension de circuit ouvert OCV de la cellule 111 pour l'instant t, à partir de la mesure U(t) de tension U, de la mesure I(t) du courant I et de l'estimation R(t) de la résistance interne R. En particulier, le module 206 est conçu pour ajouter, à la mesure U(t) de la tension U, une tension de la résistance interne R résultant du passage du courant I dans cette résistance interne R :

[Math. 4]

$$OCV(t) = U(t) + R(t) \cdot I(t)$$

où OCV(t) est l'estimation de la tension de circuit ouvert OCV pour l'instant (t).

Le programme d'ordinateur 132 comporte en outre par exemple une table 208 associant des valeurs d'une énergie totale $E_{tot}$ délivrée par la cellule 111, à des valeurs de la température T, des valeurs du courant I et des valeurs de la tension de circuit ouvert OCV. De préférence, la table donne l'énergie totale délivrée $E_{tot}$ en fonction de la tension de circuit ouvert OCV, à température T et courant I constants, pour plusieurs combinaisons de température T et de courant I. La table 208 se présente par exemple sous la forme :

[Table 2]

| $E_{tot}$ (Wh) | OCV (V) | T (°C) | I (C) |
|---|---|---|---|
| NA | 3,12 | 0 | 1 |
| 8,724 | 3,13 | 0 | 1 |
| ... | ... | ... | ... |
| 0,082 | 4,15 | 0 | 1 |
| NA | 4,16 | 0 | 1 |
| NA | 3,08 | 10 | 1 |
| 9,023 | 3,09 | 10 | 1 |
| ... | ... | ... | ... |
| 0,185 | 4,15 | 10 | 1 |
| NA | 4,16 | 10 | 1 |
| ... | | | |

D'après le tableau ci-dessus, la tension de circuit ouvert OCV minimale à la température T de 0°C et au courant I de 1C est de 3,13 V et est associée à une énergie totale délivrée $E_{tot}$ (correspondant donc à l'énergie maximale $E_{max}$ pouvant être délivrée) de 8,724 J, puisqu'aucune énergie n'est associée (case « NA ») à la valeur précédente (3,12 V) de tension de circuit ouvert OCV.

Alternativement, les associations pourraient prendre la forme, à la place de la table 208, d'une formule liant l'énergie totale délivrée $E_{tot}$ à la température T, le courant I et la tension de circuit ouvert OCV.

Le programme d'ordinateur 132 comporte en outre un module 210 conçu pour estimer l'énergie totale $E_{tot}(t)$ délivrée par la cellule 111 jusqu'à l'instant t, à partir de le mesure T(t) de la température T, de la mesure I(t) du courant I et de l'estimation OCV(t) de la tension de circuit ouvert OCV, en utilisant la table 208. Par exemple, le module 210 est conçu pour estimer l'énergie totale $E_{tot}(t)$ par interpolation.

Le programme d'ordinateur 132 comporte en outre un module 212 conçu pour estimer, pour l'instant t, une énergie maximale $E_{max}(t)$ pouvant être délivrée par la cellule 111, en supposant que la température T et le courant I restent constants à leur mesures T(t), I(t) pour l'instant t. Par exemple, le module 212 est conçu pour utiliser la table 208. En effet, pour chaque combinaison de température T et de courant I, la tension de circuit ouvert OCV diminue pendant que l'énergie totale délivrée $E_{tot}$ augmente, jusqu'à une valeur minimale en dessous de laquelle la cellule 111 n'est plus capable de fournir de l'énergie électrique. Ainsi, l'énergie maximale $E_{max}$ est l'énergie totale délivrée $E_{tot}$ pour la tension de circuit ouvert minimale $OCV_{min}$, à la température T et au courant I considérés. Ainsi, l'énergie maximale $E_{max}$ peut être déduite de la table 208 en cherchant dans cette dernière, pour la température T et le courant I à leur mesures T(t), I(t), la tension de circuit ouvert minimale $OCV_{min}$ et l'énergie totale délivrée $E_{tot}$ associée.

Le programme d'ordinateur 132 comporte en outre un module 214 conçu pour estimer l'état d'énergie SOE(t) de la cellule 111 pour l'instant t, en retranchant l'énergie totale délivrée $E_{tot}(t)$ à l'énergie maximale $E_{max}(t)$ :

[Math. 5]

$$SOE(t) = E_{max}(t) - E_{tot}(t)$$

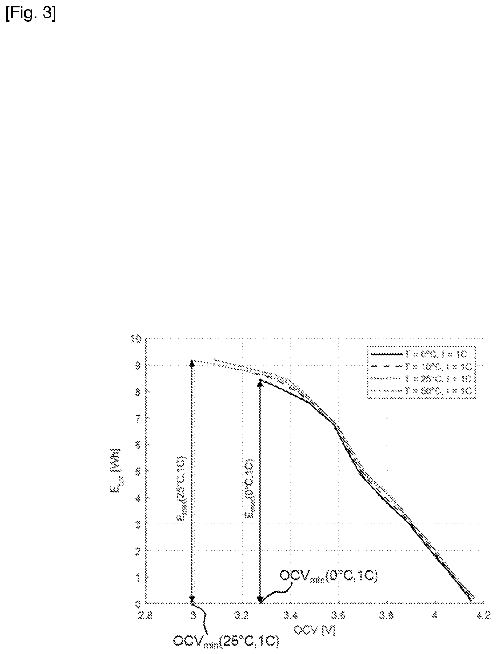

En référence à la figure 3, des exemples de courbes liant l'énergie totale délivrée $E_{tot}$ à la tension de circuit ouvert OCV, pour plusieurs combinaisons de température T et de courant I sont illustrés. Ces courbes représentent donc les données enregistrées dans la table 208.

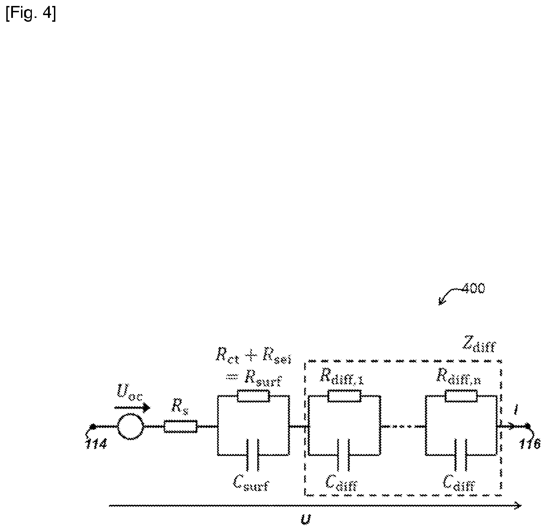

En référence à la figure 4, un exemple d'un modèle 400 de la cellule 111 va à présent être décrit.

Le modèle 400 comporte des blocs connectés en série entre les deux bornes 114, 116. La cellule 111 présente la tension U entre ces bornes 114, 116 et échange le courant I par ces bornes 114, 116.

Un premier bloc comporte une source de tension $U_{oc}$ représentant la tension de circuit ouvert de la cellule 111, c'est-à-dire la tension que présente cette cellule 111 lorsqu'elle est complètement relaxée.

Un deuxième bloc comporte une résistance série $R_s$ représentant toutes les contributions purement résistives, telles que l'électrolyte, les collecteurs de courant et les résistances de contact.

Un troisième bloc comporte une résistance $R_{surf}$ et une capacité $C_{surf}$ en parallèle l'un de l'autre, représentant la résistance et la capacité de surface liée à la chute de tension entre la surface de la matière active et de l'électrolyte due au transfert de charge et à l'interphase électrolytique solide (de l'anglais « Solid Electrolyte Interphase » également désigné par l'acronyme SEI). La résistance $R_{surf}$ et la capacité $C_{surf}$ définissent ainsi une constante de temps $\tau_{surf} = R_{surf}C_{surf}$ liée aux phénomènes de surface (transfert de charge, SEI et double couche). Il s'agit d'une dynamique rapide, normalement inférieure à une seconde.

n blocs (n supérieur ou égal à 1) comportent chacun une résistance $R_{diff}$ et une capacité $C_{diff}$ représentant des phénomènes de diffusion des ions de lithium dans l'électrolyte et des atomes de lithium dans les deux électrodes. La résistance $R_{diff}$ et la capacité $C_{diff}$ de chacun de ces n blocs définit une constante de temps $\tau_{diff} = R_{diff}C_{diff}$ liée aux phénomènes de diffusion. Il s'agit d'une dynamique lente, de l'ordre de plusieurs secondes ou minutes.

Tous ces paramètres dépendent de l'état de charge SOC de la cellule 111, de la température T de la cellule 111 et du courant I dans la cellule 111, à l'exception de la source de tension $U_{oc}$ qui ne dépend pas du courant I. Le modèle 400 comporte ainsi par exemple une table pour chacun d'eux, donnant la valeur du paramètre considéré en fonction de l'état de charge SOC, de la température T et, le cas échéant, du courant I.

Ainsi, dans le modèle 400, la résistance interne R de la cellule 111 est égale à la somme des résistances Rs, Rsurf et Rdiff des n blocs :

[Math. 3]

$$R = R_s + R_{surf} + R_{diff,1} + \cdots + R_{diff,n}$$

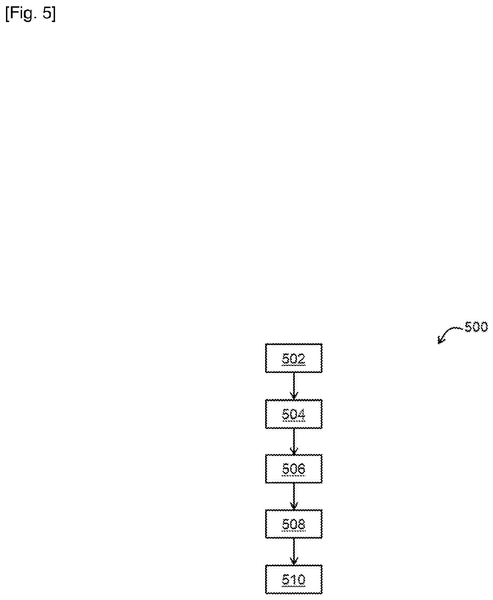

En référence à la figure 5, un exemple de procédé 500 de détermination de la table 208 va à présent être décrit.

Au cours d'une étape 502, une valeur de température T et de courant I sont sélectionnés.

Au cours d'une étape 504, une décharge complète de la cellule 111 est simulée au moyen du modèle 400, en gardant constants la température T et le courant I à leurs valeurs sélectionnées.

Au cours d'une étape 506, une énergie électrique fournie pour la cellule et une énergie thermique dissipée par effet joule au cours du temps de la simulation sont calculés à partir du résultat de la simulation. L'énergie totale délivrée $E_{tot}$ à chacun de plusieurs instants de la simulation est alors calculée comme la somme de l'énergie électrique fournie et de l'énergie thermique dissipée à l'instant de la simulation considéré.

Au cours d'une étape 508, la tension de circuit ouvert OCV est également calculée pour chacun des instants de la simulation, à partir du résultat de la simulation.

Au cours d'une étape 510, pour chacun des instants de la simulation, les valeurs d'énergie totale délivrée $E_{tot}$ et de tension de circuit ouvert OCV associées, sont enregistrées dans la table 208, avec les valeurs de température T et courant I.

Le procédé 500 retourne alors à l'étape 502 pour la sélection de nouvelles valeurs de température T et de courant I.

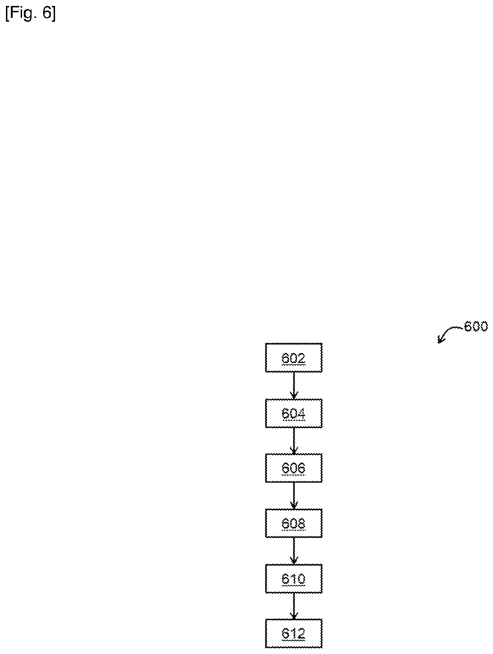

En référence à la figure 6, un exemple d'un procédé 600 d'estimation de l'état d'énergie SOE(t) de la cellule 111 à un instant t, va à présent être décrit.

Au cours d'une étape 602, le module 202 reçoit les mesures T(t), U(t), I(t) de la température T, la tension U et le courant I, pour l'instant t.

Au cours d'une étape 604, le module 204 estime la résistance interne R(t) de la cellule 111 pour l'instant t.

Au cours d'une étape 606, le module 206 estime la tension de circuit ouvert OCV de la cellule 111 pour l'instant t, à partir de la mesure U(t) de la tension U, de la mesure I(t) du courant I et de l'estimation R(t) de la résistance interne R.

Au cours d'une étape 608, le module 210 estime l'énergie totale délivrée $E_{tot}$(t) par la cellule 111 jusqu'à l'instant t, à partir de la mesure T(t) de la température T, de la mesure I(t) du courant I et de l'estimation OCV(t) de la tension de circuit ouvert OCV.

Au cours d'une étape 610, le module 212 estime, pour l'instant t, l'énergie maximale $E_{max}$(t) pouvant être délivrée par la cellule 111, en supposant que la température T et le courant I restent constants.

Au cours d'une étape 612, le module 214 estime, pour l'instant t, l'état d'énergie SOE(t) de la cellule 111, en retranchant l'énergie totale délivrée $E_{tot}$(t) à l'énergie maximale $E_{max}$(t).

En conclusion, on notera que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

## Revendications

1. Procédé (600) d'estimation d'un état d'énergie (SOE) d'une cellule (111) d'une batterie (110) pour un instant donné (t), la cellule (111) présentant deux bornes (114, 116), **caractérisé en ce qu'**il comporte :

   - une réception (602) de mesures pour l'instant donné (t) d'une température (T) de la cellule (111), d'une tension (U) aux bornes (112, 114) de la cellule (111) et d'un courant (I) échangé par la cellule (111) au travers de ses bornes (114, 116) ;
   - une estimation (604) d'une résistance interne (R) de la cellule (111) pour l'instant donné (t) ;
   - une estimation (606) d'une tension de circuit ouvert (OCV) de la cellule (111) pour l'instant donné (t) à partir de la tension (U) et du courant (I) mesurés, et de la résistance interne (R) estimée, par exemple en ajoutant à la tension (U) mesurée, une tension de la résistance interne (R) résultant d'un passage du courant (I) mesuré dans la résistance interne (R) ;
   - une estimation (608) d'une énergie totale ($E_{tot}$) délivrée par la cellule (111) jusqu'à l'instant donné (t), à partir de la température (T) et du courant (I) mesurés, et de la tension de circuit ouvert (OCV) estimée, en utilisant des associations prédéfinies (208) entre des valeurs d'énergie totale ($E_{tot}$) délivrée par la cellule (111) et des valeurs de température (T), de courant (I) et de tension de circuit ouvert (OCV) ;
   - une estimation (610) d'une énergie maximale ($E_{max}$) pouvant être délivrée par la cellule (111), en utilisant les associations prédéfinies (208) et en supposant que la température (T) et le courant (I) restent constants à leurs mesures pour l'instant donné (t) ; et
   - une estimation (612) de l'état d'énergie (SOE) de la cellule (111) pour l'instant donné (t), en retranchant l'énergie totale délivrée ($E_{tot}$) estimée de l'énergie maximale ($E_{max}$) estimée.

2. Procédé (600) selon la revendication 1, dans lequel l'estimation de la résistance interne (R) pour l'instant donné (t) est réalisée à partir d'une mesure volt-ampérométrique.

3. Procédé (600) selon la revendication 1, dans lequel l'estimation (604) de la résistance interne (R) à l'instant donné (t), comporte :

   - une estimation préalable de la résistance interne (R) pour l'instant donné (t) à partir de la température (T) et du courant (I) mesurés à l'instant donné (t), en utilisant des associations prédéfinie (205) entre des valeurs de la résistance interne (R) et des valeurs de température (T) et de courant (I) ;
   - une correction de l'estimation préalable en la multipliant par un rapport de correction (K) entre :

     • une estimation de la résistance interne (R) à un instant antérieur par une mesure volt-ampérométrique, et
     • une estimation de la résistance interne (R) à l'instant antérieur à partir de la température (T) et du courant (I) mesurés à l'instant antérieur, en utilisant les associations prédéfinies (205) entre des valeurs de la résistance interne (R) et des valeurs de température (T) et de courant (I).

4. Procédé (600) selon l'une quelconque des revendications 1 à 3, dans lequel l'estimation (604) de la résistance interne (R) à l'instant donné (t) est réalisée indépendamment d'un état de charge (SOC) de la cellule (111).

5. Procédé (600) selon l'une quelconque des revendications 1 à 4, dans lequel les associations prédéfinies (208) entre des valeurs d'énergie totale ($E_{tot}$) délivrée par la cellule (111) et des valeurs de température (T), de courant (I) et de tension de circuit ouvert (OCV) sont sous la forme d'une table.

6. Procédé (600) selon la revendication 5, dans lequel la table donne l'énergie totale délivrée ($E_{tot}$) en fonction de la tension de circuit ouvert (OCV), à température (T) et courant (I) constants, pour plusieurs combinaisons de température (T) et de courant (I).

7. Procédé (600) selon l'une quelconque des revendications 1 à 6, dans lequel l'énergie maximale ($E_{max}$) est l'énergie totale délivrée ($E_{tot}$) pour une tension de circuit ouvert minimale ($OCV_{min}$) prévue par les associations prédéfinies (208), à la température (T) et au courant (I) mesurés à l'instant donné (t).

8. Programme d'ordinateur (132) téléchargeable depuis un réseau de communication et/ou enregistré sur un support lisible par ordinateur, **caractérisé en ce qu'**il comprend des instructions pour l'exécution des étapes d'un procédé (600) selon l'une quelconque des revendications 1 à 7, lorsque ledit programme est exécuté sur un ordinateur.

9. Dispositif d'estimation d'un état d'énergie (SOE) d'une cellule (111) d'une batterie (110) pour un instant donné (t), la cellule (111) présentant deux bornes (114, 116) entre lesquelles un système électrique (108) est connecté, **caractérisé en ce qu'**il comporte :

   - un module (202) de réception, pour l'instant donné (t), de mesures d'une température (T) de la cellule (111), d'une tension (U) aux bornes (112, 114) de la cellule (111) et d'un courant (I) échangé par la cellule (111) au travers de ses bornes (112, 114) ;
   - un module (204) d'estimation d'une résistance interne (R) de la cellule (111) pour l'instant donné (t) ;
   - un module (206) d'estimation d'une tension de circuit ouvert (OCV) de la cellule (111) pour l'instant donné (t) à partir de la tension (U) et du courant (I) mesurés, et de la résistance interne (R) estimée, par exemple en ajoutant à la tension (U) mesurée, une tension de la résistance interne (R) résultant d'un passage du courant (I) mesuré dans la résistance interne (R) ;
   - un module (210) d'estimation d'une énergie totale ($E_{tot}$) délivrée par la cellule (111) à partir de la température (T) et du courant (I) mesurés, et de la tension de circuit ouvert (OCV) estimée, en utilisant des associations prédéfinies (208) entre des valeurs d'énergie totale ($E_{tot}$) délivrée par la cellule (111) et des valeurs de température (T), de courant (I) et de tension de circuit ouvert (OCV) ;
   - un module (212) d'estimation d'une énergie maximale ($E_{max}$) pouvant être délivrée par la cellule (111) en supposant que la température (T) et le courant (I) restent constants à leurs mesures pour l'instant donné (t) ; et
   - un module (214) d'estimation de l'état d'énergie (SOE) de la cellule (111) pour l'instant donné (t), en retranchant l'énergie totale délivrée ($E_{tot}$) estimée de l'énergie maximale ($E_{max}$) estimée.

10. Aéronef (100) comportant :

   - une batterie (110) comportant au moins une cellule (111) présentant deux bornes (112, 114) ;
   - un capteur (118) d'une température (T) de la cellule (111) ;
   - un capteur (120) d'un courant (I) échangé par la cellule (111) au travers de ses bornes (112, 114) ;
   - un capteur (122) d'une tension (U) entre les bornes (112, 114) de la cellule (111) ; et
   - un dispositif d'estimation d'un état d'énergie (SOE) de la cellule (111), selon la revendication 9.

**Patentansprüche**

1. Verfahren (600) zum Schätzen eines Energiezustands (SOE) einer Zelle (111) einer Batterie (110) zu einem gegebenen Zeitpunkt (t), wobei die Zelle (111) zwei Anschlüsse (114, 116) aufweist, **dadurch gekennzeichnet, dass** es umfasst:

   - Empfangen (602) von Messungen zum gegebenen Zeitpunkt (t) einer Temperatur (T) der Zelle (111), einer Spannung (U) an den Anschlüssen (112, 114) der Zelle (111) und eines Stroms (I), der von der Zelle (111) über ihre Anschlüsse (114, 116) ausgetauscht wird;
   - Schätzen (604) eines Innenwiderstands (R) der Zelle (111) zum gegebenen Zeitpunkt (t);
   - Schätzen (606) einer Leerlaufspannung (OCV) der Zelle (111) zum gegebenen Zeitpunkt (t) aus der gemessenen Spannung (U) und dem gemessenen Strom (I) und dem geschätzten Innenwiderstand (R), beispielsweise durch Addieren zu der gemessenen Spannung (U) einer Spannung des Innenwiderstands (R), die sich aus dem Durchfluss des gemessenen Stroms (I) durch den Innenwiderstand (R) ergibt;

- Schätzen (608) einer Gesamtenergie ($E_{tot}$), die von der Zelle (111) bis zu einem gegebenen Zeitpunkt (t) abgegeben wird, aus der gemessenen Temperatur (T) und dem gemessenen Strom (I) und der geschätzten Leerlaufspannung (OCV) unter Verwendung vordefinierter Zuordnungen (208) zwischen den Werten der Gesamtenergie ($E_{tot}$), die von der Zelle (111) abgegeben wird, und den Werten der Temperatur (T), des Stroms (I) und der Leerlaufspannung (OCV);

- Schätzen (610) einer maximalen Energie ($E_{max}$), die von der Zelle (111) unter Verwendung der vordefinierten Zuordnungen (208) und unter der Annahme, dass die Temperatur (T) und der Strom (I) zum gegebenen Zeitpunkt (t) konstant bleiben, abgegeben werden kann; und

- Schätzen (612) des Energiezustands (SOE) der Zelle (111) zum gegebenen Zeitpunkt (t) durch Subtrahieren der geschätzten Gesamtabgabenenergie ($E_{tot}$) von der geschätzten maximalen Energie ($E_{max}$) estimée.

2. Verfahren (600) nach Anspruch 1, wobei das Schätzen des Innenwiderstands (R) zum gegebenen Zeitpunkt (t) anhand einer volt-amperometrischen Messung durchgeführt wird.

3. Verfahren (600) nach Anspruch 1, wobei das Schätzen (604) des Innenwiderstands (R) zum gegebenen Zeitpunkt (t) umfasst:

- Vorabschätzen des Innenwiderstands (R) für den gegebenen Zeitpunkt (t) aus der Temperatur (T) und dem Strom (I), die zum gegebenen Zeitpunkt (t) gemessen werden, unter Verwendung vordefinierter Zuordnungen (205) zwischen Werten des Innenwiderstands (R) und Werten der Temperatur (T) und des Stroms (I);
- Korrigieren der Vorabschätzung durch Multiplizieren mit einem Korrekturfaktor (K) zwischen:
- einer Schätzung des Innenwiderstands (R) zu einem früheren Zeitpunkt durch eine volt-amperometrische Messung und
- einer Schätzung des Innenwiderstands (R) zu dem früheren Zeitpunkt aus der Temperatur (T) und dem Strom (I), die zu dem früheren Zeitpunkt gemessen werden, unter Verwendung der vordefinierten Zuordnungen (205) zwischen Werten des Innenwiderstands (R) und Werten der Temperatur (T) und des Stroms (I).

4. Verfahren (600) nach einem der Ansprüche 1 bis 3, wobei das Schätzen (604) des Innenwiderstands (R) zum gegebenen Zeitpunkt (t) unabhängig von einem Ladezustand (SOC) der Zelle (111) durchgeführt wird.

5. Verfahren (600) nach einem der Ansprüche 1 bis 4, wobei die vordefinierten Zuordnungen (208) zwischen den Werten der Gesamtenergie ($E_{tot}$), die von der Zelle (111) abgegeben wird, und den Werten für Temperatur (T), Strom (I) und Leerlaufspannung (OCV) in Form einer Tabelle vorliegen.

6. Verfahren (600) nach Anspruch 5, wobei die Tabelle die Gesamtabgabenenergie ($E_{tot}$) als Funktion der Leerlaufspannung (OCV) bei konstanter Temperatur (T) und konstantem Strom (I) für mehrere Kombinationen von Temperatur (T) und Strom (I) angibt.

7. Verfahren (600) nach einem der Ansprüche 1 bis 6, wobei die maximale Energie ($E_{max}$) die Gesamtabgabenenergie ($E_{tot}$) für eine minimale Leerlaufspannung ($OCV_{min}$) ist, die durch die vordefinierten Zuordnungen (208) bei der zum gegebenen Zeitpunkt (t) gemessenen Temperatur (T) und dem gemessenen Strom (I) vorgesehen ist.

8. Computerprogramm (132), das aus einem Kommunikationsnetzwerk heruntergeladen und/oder auf einem computerlesbaren Medium gespeichert werden kann, **dadurch gekennzeichnet, dass** es Anweisungen zur Ausführung der Schritte eines Verfahrens (600) nach einem der Ansprüche 1 bis 7 umfasst, wenn das Programm auf einem Computer ausgeführt wird.

9. Vorrichtung zum Schätzen eines Energiezustands (SOE) einer Zelle (111) einer Batterie (110) zu einem gegebenen Zeitpunkt (t), wobei die Zelle (111) zwei Anschlüsse (114, 116) aufweist, zwischen denen ein elektrisches System (108) angeschlossen ist, **dadurch gekennzeichnet, dass** sie umfasst:

- ein Modul (202) zum Empfangen, zum gegebenen Zeitpunkt (t), von Messungen einer Temperatur (T) der Zelle (111), einer Spannung (U) an den Anschlüssen (112, 114) der Zelle (111) und eines von der Zelle (111) über ihre Anschlüsse (112, 114) ausgetauschten Stroms (I);
- ein Modul (204) zum Schätzen eines Innenwiderstands (R) der Zelle (111) zum gegebenen Zeitpunkt (t);
- ein Modul (206) zum Schätzen einer Leerlaufspannung (OCV) der Zelle (111) zum gegebenen Zeitpunkt (t) aus der gemessenen Spannung (U) und dem gemessenen Strom (I) und dem geschätzten Innenwiderstand (R), beispielsweise durch Addieren zur gemessenen Spannung (U) einer Spannung des Innenwiderstands (R), die sich aus dem Durchfluss des gemessenen Stroms (I) durch den Innenwiderstand (R) ergibt;

- ein Modul (210) zum Schätzen einer Gesamtenergie ($E_{tot}$), die von der Zelle (111) abgegeben wird, aus der gemessenen Temperatur (T) und dem gemessenen Strom (I) und der geschätzten Leerlaufspannung (OCV) unter Verwendung vordefinierter Zuordnungen (208) zwischen Werten der Gesamtenergie ($E_{tot}$) der Zelle (111) und den Werten der Temperatur (T), des Stroms (I) und der Leerlaufspannung (OCV);

- ein Modul (212) zum Schätzen einer maximalen Energie ($E_{max}$), die von der Zelle (111) abgegeben werden kann, unter der Annahme, dass die Temperatur (T) und der Strom (I) bei ihren Messungen zum gegebenen Zeitpunkt (t) konstant bleiben; und

- ein Modul (214) zum Schätzen des Energiezustands (SOE) der Zelle (111) zum gegebenen Zeitpunkt (t) durch Subtrahieren der geschätzten Gesamtabgabenergie ($E_{tot}$) von der geschätzten maximalen Energie ($E_{max}$).

**10.** Flugzeug (100), umfassend:

- eine Batterie (110), die mindestens eine Zelle (111) umfasst, die zwei Anschlüsse (112, 114) aufweist;
- einen Sensor (118) für die Temperatur (T) der Zelle (111);
- einen Sensor (120) für den Strom (I), der von der Zelle (111) über ihre Anschlüsse (112, 114) ausgetauscht wird;
- einen Sensor (122) für die Spannung (U) zwischen den Anschlüssen (112, 114) der Zelle (111); und
- eine Vorrichtung zum Schätzen eines Energiezustands (SOE) der Zelle (111) nach Anspruch 9.

**Claims**

**1.** A method (600) for estimating a state of energy (SOE) of a cell (111) of a battery (110) for a given instant (t), the cell (111) having two terminals (114, 116), the method being **characterized in that** it comprises:

- receiving (602) measurements for the given instant (t) of a temperature (T) of the cell (111), a voltage (U) at the terminals (112, 114) of the cell (111) and a current (I) exchanged by the cell (111) across its terminals (114, 116);
- estimating (604) an internal resistance (R) of the cell (111) for the given instant (t);
- estimating (606) an open circuit voltage (OCV) of the cell (111) for the given instant (t) from the measured voltage (U) and current (I), and from the estimated internal resistance (R), for example by adding to the measured voltage (U) a voltage of the internal resistance (R) resulting from a passage of the measured current (I) through the internal resistance (R);
- estimating (608) a total energy ($E_{tot}$) delivered by the cell (111) up to the given instant (t), from the measured temperature (T) and current (I), and from the estimated open circuit voltage (OCV), using predefined associations (208) between values of total energy ($E_{tot}$) delivered by the cell (111) and values of temperature (T), current (I) and open circuit voltage (OCV);
- estimating (610) a maximum energy ($E_{max}$) that may be delivered by the cell (111), using the predefined associations (208) and assuming that the temperature (T) and the current (I) remain constant at their measurements for the given instant (t); and
- estimating (612) the state of energy (SOE) of the cell (111) for the given instant (t), by subtracting the estimated total delivered energy ($E_{tot}$) from the estimated maximum energy ($E_{max}$).

**2.** The method (600) according to claim 1, wherein the internal resistance (R) is estimated for the given instant (t) on the basis of a volt-amperometric measurement.

**3.** The method (600) according to claim 1, wherein the estimation (604) of the internal resistance (R) at the given instant (t) comprises:

- a prior estimation of the internal resistance (R) for the given instant (t) from the temperature (T) and current (I) measured at the given instant (t), using predefined associations (205) between values of the internal resistance (R) and values of temperature (T) and current (I);
- a correction of the prior estimation by multiplying it by a correction ratio (K) between:

  ○ an estimation of the internal resistance (R) at a previous instant by a volt-amperometric measurement, and
  ○ an estimation of the internal resistance (R) at the previous instant from the temperature (T) and current (I) measured at the previous instant, using the predefined associations (205) between values of the internal resistance (R) and values of temperature (T) and current (I).

4. The method (600) according to any one of claims 1 to 3, wherein the estimation (604) of the internal resistance (R) at the given instant (t) is carried out independently of a state of charge (SOC) of the cell (111).

5. The method (600) according to any one of claims 1 to 4, wherein the predefined associations (208) between values of total energy ($E_{tot}$) delivered by the cell (111) and values of temperature (T), current (I) and open circuit voltage (OCV) are in the form of a table.

6. The method (600) according to claim 5, wherein the table gives the total energy delivered ($E_{tot}$) as a function of the open circuit voltage (OCV), at constant temperature (T) and current (I), for several combinations of temperature (T) and current (I).

7. The method (600) according to any one of claims 1 to 6, wherein the maximum energy ($E_{max}$) is the total energy delivered ($E_{tot}$) for a minimum open circuit voltage ($OCV_{min}$) provided by the predefined associations (208), at the temperature (T) and current (I) measured at the given instant (t).

8. A computer program (132) downloadable from a communications network and/or recorded on a computer-readable medium, **characterized in that** it comprises instructions for executing the steps of a method (600) according to any one of claims 1 to 7, when said program is executed on a computer.

9. A device for estimating a state of energy (SOE) of a cell (111) of a battery (110) for a given instant (t), the cell (111) having two terminals (114, 116) between which an electrical system (108) is connected, the device being **characterized in that** it comprises:

- a module (202) for receiving, for the given instant (t), measurements of a temperature (T) of the cell (111), a voltage (U) at the terminals (112, 114) of the cell (111) and a current (I) exchanged by the cell (111) across its terminals (112, 114);
- a module (204) for estimating an internal resistance (R) of the cell (111) for the given instant (t);
- a module (206) for estimating an open circuit voltage (OCV) of the cell (111) for the given instant (t) from the measured voltage (U) and current (I), and from the estimated internal resistance (R), for example by adding to the measured voltage (U) a voltage of the internal resistance (R) resulting from a passage of the measured current (I) through the internal resistance (R);
- a module (210) for estimating a total energy ($E_{tot}$) delivered by the cell (111) from the measured temperature (T) and current (I), and from the estimated open circuit voltage (OCV), using predefined associations (208) between values of total energy ($E_{tot}$) delivered by the cell (111) and values of temperature (T), current (I) and open circuit voltage (OCV);
- a module (212) for estimating a maximum energy ($E_{max}$) that may be delivered by the cell (111) assuming that the temperature (T) and the current (I) remain constant at their measurements for the given instant (t); and
- a module (214) for estimating the state of energy (SOE) of the cell (111) for the given instant (t), by subtracting the estimated total delivered energy ($E_{tot}$) from the estimated maximum energy ($E_{max}$).

10. An aircraft (100) comprising:

- a battery (110) comprising at least one cell (111) with two terminals (112, 114);
- a sensor (118) for measuring a temperature (T) of the cell (111);
- a sensor (120) for measuring a current (I) exchanged by the cell (111) across its terminals (112, 114);
- a sensor (122) for measuring a voltage (U) between the terminals (112, 114) of the cell (111); and
- a device for estimating a state of energy (SOE) of the cell (111), according to claim 9.

[Fig. 1]

[Fig. 2]

[Fig. 3]

[Fig. 4]

[Fig. 5]

500

502

504

506

508

510

[Fig. 6]

600

```
┌─────────┐
│   602   │
└─────────┘
     │
     ▼
┌─────────┐
│   604   │
└─────────┘
     │
     ▼
┌─────────┐
│   606   │
└─────────┘
     │
     ▼
┌─────────┐
│   608   │
└─────────┘
     │
     ▼
┌─────────┐
│   610   │
└─────────┘
     │
     ▼
┌─────────┐
│   612   │
└─────────┘
```

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2016083932 A